# FASCICULE DE BREVET EUROPEEN

(11) **EP 0 503 731 B1**
(45) Date de publication et mention de la délivrance du brevet: **02.12.1998**
(21) Numéro de dépôt: 92200654.9
(22) Date de dépôt: 06.03.1992
(51) Int. Cl.: H01L 21/338

(54) **Procédé de réalisation d'un transistor à haute mobilité électronique intégré**
Verfahren zur Realisierung eines Transistors mit hoher Elektronenbeweglichkeit
Method of making a transistor with high electron mobility

(30) Priorité: 15.03.1991 FR 9103198
(43) Date de publication de la demande: 16.09.1992
(73) Titulaire: LABORATOIRES D'ELECTRONIQUE PHILIPS S.A.S., 94450 Limeil-Brévannes (FR); Koninklijke Philips Electronics N.V., 5621 BA Eindhoven (NL)
(72) Inventeur: Suchet, Philippe, Société Civile S.P.I.D., F-75008 Paris (FR); Vingrief, Jean Jacques, Société Civile S.P.I.D., F-75008 Paris (FR)
(74) Mandataire: Landousy, Christian

(56) Documents cités:
- US-A- 4 545 109
- GAAS IC SYMPOSIUM TECHNICAL DIGEST 22 Octobre 1989, SAN DIEGO USA pages 143 - 146; A. S. BROWN ET.AL.: 'LOW-TEMPERATURE BUFFER AlInAs/GaInAs ON InP HEMT TECHNOLOGY FOR ULTRA-HIGH-SPEED INTEGRATED CIRCUITS'
- PATENT ABSTRACTS OF JAPAN vol. 14, no. 463 (E-988)(4406) 8 Octobre 1990 & JP-A-2 188 930 ( SUMITOMO ELECTRIC ) 25 Juillet 1990
- PATENT ABSTRACTS OF JAPAN vol. 11, no. 41 (E-478)(2488) 6 Février 1987 & JP-A-61 207 080 ( SHARP ) 13 Septembre 1986

## Description

L'invention concerne un procédé de réalisation d'un circuit intégré sur un substrat comprenant des étapes pour former un transistor à haute mobilité électronique (HEMT, de l'anglais High Electron Mobility Transistor), ces étapes incluant la réalisation d'un empilement de couches, réalisées sur le substrat, parmi lesquelles se trouvent au moins une couche en un matériau de faible largeur de bande interdite, faiblement dopée, pour former le canal du transistor, et une couche donneur d'un matériau de grande largeur de bande interdite, fortement dopée, pour fournir des électrons, et ces étapes incluant la réalisation d'une zone d'isolation vis-à-vis des autres éléments du circuit intégré tout autour du transistor et la réalisation d'électrodes de grille, et de source et drain.

L'invention trouve son application dans la réalisation de circuits intégrés numériques ou analogiques.

Un procédé tel que décrit plus haut est connu de la publication par April S. BROWN et alii, de HUGHES RESEARCH LABORATORIES, intitulée "Low-Temperature Buffer AlInAs/GaInAs on InP HEMT Technology for Ultra-High-Speed Integrated Circuits", parue dans 1989 IEEE GaAs Ic SYMPOSIUM, p.143 à 146.

Le document cité décrit un procédé pour réaliser un circuit intégré incluant la formation d'un transistor à haute mobilité électronique. Ce procédé comprend la réalisation, sur un substrat en InP semi-isolant, d'une succession de couches respectivement une couche tampon de AlInAs n⁻, une couche canal de GaInAs nn⁻, une couche espaceur de AlInAs n⁻, une couche donneur de AlInAs n⁺ (fortement dopée), une couche appropriée à recevoir un contact Schottky réalisée en AlInAS n⁻ et une couche d'encapsulation de GaInAs.

A l'issue de la formation des couches, sont réalisés deux contacts de type ohmique pour constituer la source et le drain du transistor, en surface de la couche d'encapsulation. Puis une cannelure est gravée entre la source et le drain jusqu'à la couche dite Schottky, et un contact de type Schottky est réalisé par une métallisation dans cette cannelure, pour constituer la grille du transistor, par autoalignement.

Le document cité enseigne que deux techniques sont possibles pour isoler le transistor par rapport aux autres éléments du circuit intégré.

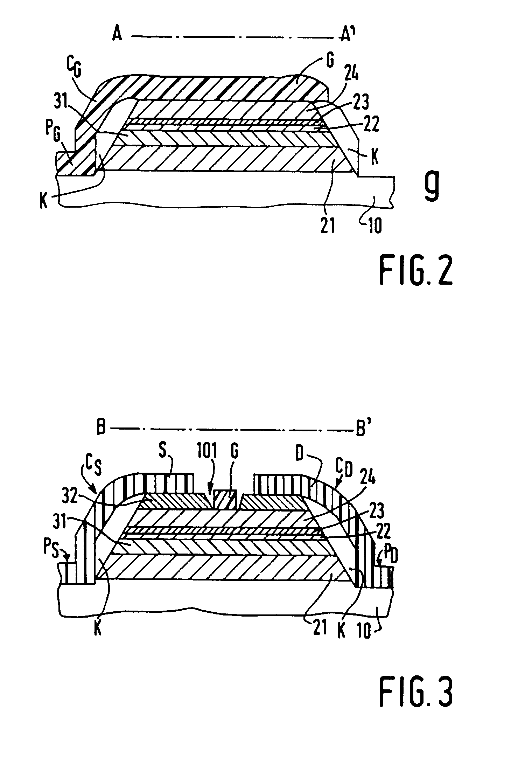

La première méthode enseignée est l'isolation par formation d'un MESA, c'est-à-dire par la réalisation d'une gravure tout autour de la région du transistor, cette gravure délimitant le transistor dont la région active se trouve alors en relief par rapport au substrat. Dans ces conditions, il est nécessaire que la métallisation de la grille Schottky suive le flanc du MESA pour relier la grille à un plot de grille disposé à proximité du transistor dans la région du substrat qui apparaît après gravure du MESA, comme il est montré sur la figure 3 du document cité.

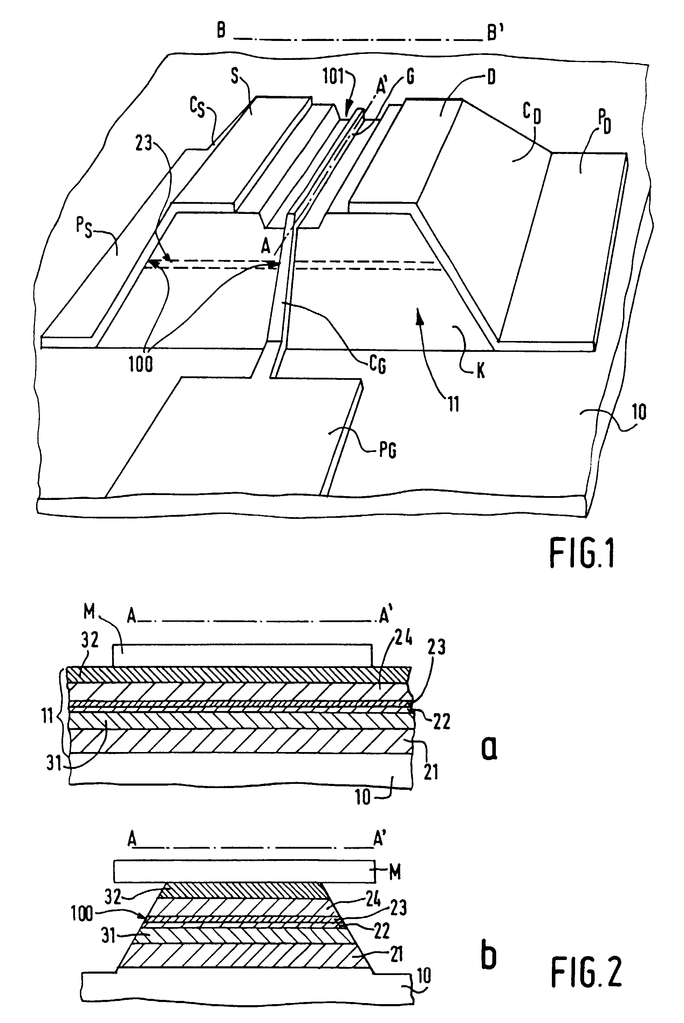

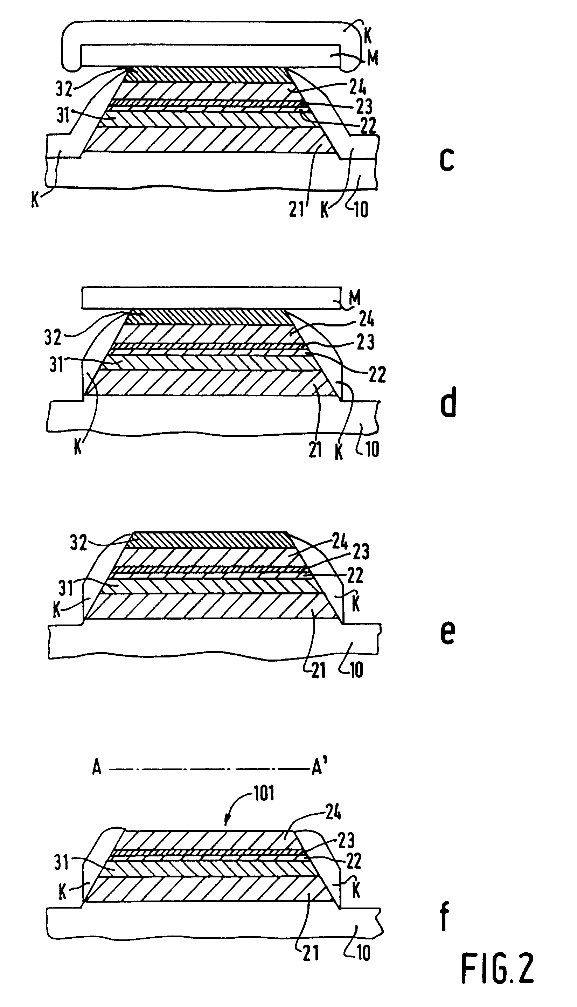

Cette disposition de la connexion entre la métallisation de grille et son plot engendre un problème grave, car la métallisation de connexion est en contact avec toutes les couches qui affleurent le flanc du MESA et particulièrement la couche fortement dopée de AlInAs n⁺, et, en fonctionnement, le transistor est affecté d'un fort courant de fuite, comme montré sur la figure 2 du document cité.

Selon l'enseignement de ce document, on évite ce courant de fuite en réalisant l'isolation du transistor, non pas par la formation d'un MESA, mais par une seconde méthode consistant en une implantation d'ions autour de la zone active, résultant dans le fait que le dispositif reste planaire.

Cependant, la seconde solution enseignée n'a pas les faveurs de l'homme du métier fabricant de circuits intégrés. En effet, l'implantation ionique pour réaliser l'isolation met en oeuvre des moyens techniques onéreux consistant dans un appareil d'implantation ionique ; de plus, elle nécessite un recuit qui a tendance à détériorer les propriétés des couches, ou des autres dispositifs du circuit intégré, déjà réalisés ; ensuite l'implantation ionique n'est pas correctement répétitive ; en outre son efficacité est moindre que celle d'un MESA. De tous ces faits, il résulte d'abord que le rendement de fabrication d'un circuit intégré incluant des étapes d'isolation par implantation ionique peut se trouver notablement restreint au lieu d'atteindre des chiffres aussi voisins que possible de 100 % comme espéré par le fabricant de circuits intégrés, et il résulte ensuite que le coût du circuit intégré est élevé.

L'homme du métier se trouve donc confronté au problème d'éviter les étapes d'implantation ionique, et donc d'envisager la formation de MESA d'isolation. Mais il se trouve alors devant le double problème :
- de réaliser un transistor dépourvu de courants de fuite,
- de réaliser ce transistor sans augmenter le nombre des étapes du procédé de réalisation.

En effet, toute augmentation du nombre des étapes peut produire une somme d'inconvénients : c'est-à-dire à la fois augmenter le coût de fabrication, et diminuer le rendement de fabrication, ce qui résulte aussi en une augmentation du coût final de fabrication.

Or, dans l'état actuel de la compétition entre fabricants de circuits intégrés, la moindre augmentation des coûts peut résulter en une perte totale du marché. Il est donc de la plus haute importance de minimiser ces coûts. Ce qui peut ne sembler, a priori, qu'un détail dans le procédé de fabrication, ou, toujours a priori, une étape équivalente, peut se révéler pour le fabricant de circuits intégrés, selon le cas, comme un facteur de désastre économique, ou au contraire comme un moyen de maintenir son rang sur la marché.

C'est pourquoi, selon l'invention, est proposé un procédé de réalisation tel que décrit dans le préambule, et en outre caractérisé en ce qu'il comprend aussi les étapes de :
- formation en surface de l'empilement de couches, d'un masque couvrant et délimitant la zone active du transistor ;
- gravure anisotrope de l'empilement de couches jusqu'au substrat avec sous-gravure sous le masque, pour isoler la zone active par un MESA ;
- réalisation par dépôt anisotrope d'une couche diélectrique ;
- gravure directive de la couche diélectrique en conservant les parties de cette couche qui sont protégées par le masque du fait de la sous-gravure et qui sont disposées sur les flancs du MESA autour de la zone active du transistor ;
- élimination du masque.

Selon ce procédé, l'isolation du transistor est faite par la formation de MESA, ce qui évite tous les inconvénients liés à l'implantation ionique, et ce qui procure les avantages recherchés de :
- l'isolation grâce à la couche diélectrique de la connexion de grille par rapport à la couche fortement dopée ainsi que par rapport aux autres couches, et donc la réduction des courants de fuite dans les mêmes proportions que par le procédé connu ;
- l'augmentation des autres performances du transistor par rapport à celle du transistor connu, due à une meilleure isolation de ce transistor par rapport aux autres composants réalisés sur le substrat ;
- l'augmentation du rendement de fabrication du fait de la moins grande dispersion des caractéristiques des composants due à la meilleure isolation de chaque transistor et à la simplicité du procédé de réalisation ;
- la diminution d'une part du coût de l'équipement nécessaire à la réalisation des circuits intégrés, car il n'est pas nécessaire de prévoir de dispositif pour l'implantation ionique, et d'autre part du coût de fabrication lui-même du fait des hauts rendements de fabrication et de la simplicité du procédé.

L'invention est décrite ci-après en détail, en référence avec les figures schématiques annexées, parmi lesquelles :
- la figure 1 représente un transistor HEMT vu en perspective, réalisé sur un substrat,
- les figures 2 illustrent d'une façon simplifiée les différentes étapes du procédé de réalisation de l'isolation du transistor et de la métallisation de grille en coupe selon l'axe AA' de la figure 1,
- la figure 3 représente une coupe simplifiée selon l'axe BB' de la figure 1.

L'invention concerne un procédé de réalisation avantageux d'un transistor à haute mobilité électronique (en anglais HEMT) en synergie de fabrication avec les autres éléments d'un circuit intégré. Les propriétés du HEMT considéré en tant que tel sont bien connues de l'homme du métier des circuits intégrés, tant numériques qu'analogiques, en toutes technologies, et de ce fait ne seront pas décrites ici plus avant.

Ce transistor comprend un empilement de couches réalisées sur un substrat, parmi lesquelles se trouvent de préférence une première couche 31 en un matériau de faible largeur de bande interdite, faiblement dopée pour former le canal du transitor, une seconde couche 22 en un matérieu de largeur de bande interdite plus grande faiblement dopée pour que puisse se former un gaz bidimensionnel d'électrons à l'interface avec ladite première couche 31, et pour séparer spatialement les électrons de ce gaz bidimensionnel des charges de la couche suivante, et une troisième couche 23 du matériau de grande largeur de bande interdite, fortement dopée pour fournir des électrons pouvant être transférés dans le gaz bidimensionnel.

Ces couches sont surmontées d'une quatrième couche 24 avec laquelle est réalisé un contact de type Schottky pour constituer la grille G du transistor.

Le transistor est en outre muni de moyens d'isolation par rapport à d'autres éléments de circuit intégré réalisés sur le même substrat. Selon l'invention ces moyens d'isolation consistent en la réalisation d'un MESA, et non pas une implantation ionique considérée comme coûteuse et défavorable dans l'industrie des circuits intégrés.

Un but de l'invention est de fournir un procédé pour réaliser un tel HEMT qui soit dépourvu des courants de fuite qui apparaîtraient dans le transistor lors de son fonctionnement, si du fait du MESA, la métallisation de grille G venait à se trouver en contact avec la couche fortement dopée incluse dans la région active et qui affleure aux flancs du MESA. Un autre but de l'invention est de fournir un tel procédé approprié à être mis en oeuvre sans remplacer l'étape coûteuse d'implantation ionique connue par d'autres étapes tout aussi coûteuses pour arriver au but précité, comme par exemple une ou des étapes de masquage supplémentaires (une étape de masquage étant considérée comme coûteuse du fait qu'elle inclut des sous-étapes de définition d'un masque optique toujours coûteux puis mise en oeuvre d'une photolithographie).

La figure 1 montre en perspective une représentation simplifiée d'un transistor HEMT obtenue par le procédé selon l'invention.

Ce transistor comprend, érigé sur un substrat 10, un empilement 11 de plusieurs couches semiconductrices. Il comprend en outre, en surface de ces couches dites couches actives, respectivement une électrode de source S, une électrode de grille G et une électrode de drain D. La structure érigée est dite MESA. Les électrodes de source, grille et drain sont reliées par des connexions métalliques, respectivement C_{S}, C_{G} et C_{D}, à des plots de source, grille et drain, respectivement P_{S}, P_{G} et P_{D} disposés autour du MESA sur le substrat 10 dans des régions non actives.

A cet effet, il est favorable que le substrat 10 soit semi-isolant.

Les connexions métalliques C_{S}, C_{G} et C_{D} sont donc disposées le long des flancs 100 du MESA. Pour éviter le contact de ces connexions, et tout particulièrement le contact de la connexion de grille C_{G}, avec la couche fortement dopée, par exemple 23, le long des flancs 100 du MESA, ces flancs 100 sont munis d'une couche diélectrique K, réalisant l'isolation électrique, au cours des étapes de réalisation du MESA, sans rallonger le procédé de réalisation du circuit intégré dans lequel est inclus le HEMT, ou augmenter son coût.

Ce procédé est décrit ci-après en référence avec les figures 2a à 2g, dans le cas où le transistor HEMT est mis en oeuvre sur un substrat en InP (Phosphore d'Indium) semi-isolant. La composition et l'épaisseur des couches sont données à titre purement exemplatif ; en effet le procédé selon l'invention peut s'appliquer à de nombreux autres cas où l'on forme un composant isolé par un MESA.

En référence avec les figures 2a à 2g, le procédé comprend de préférence la succession des étapes de :
a) formation (voir la figure 2a) en surface d'un substrat 10, semi-isolant, favorablement en InP, des couches actives du transistor, par croissance épitaxiale. Les couches auront favorablement les compositions et l'épaisseur données dans le tableau I en liaison avec leur numéro de référence sur les figures 2. A partir du substrat, on trouve dans l'ordre une couche 21 de AlInAs (Arséniure d'Indium et d'Aluminium) servant de tampon, faible dopée de type n⁻, par exemple ayant seulement le dopage résiduel de croissance, c'est-à-dire non dopée intentionnellement ; une couche 31 de GaInAs (Arséniure d'Indium et de Gallium) formant le canal par exemple non dopée intentionnellement ; une couche 22 de AlInAs (Arséniure d'Indium et d'Aluminium) servant d'espaceur par exemple non dopée intentionnellement ; une couche donneur 23 de AlInAs (Arséniure d'Indium et d'Aluminium) fortement dopée de type n⁺, par exemple au moyen d'espèces telles que Si ; une couche 24 de AlInAs (Arséniure d'Indium et d'Aluminium) dite couche Schottky, par exemple non dopée intentionnellement avec laquelle est réalisé le contact d'électrode de grille G ; et en surface, une couche 32 dite d'encapsulation (en anglais CAP layer) de GaInAs (Arséniure d'Indium et de Gallium) fortement dopée de type n⁺ pour réduire les résistances d'accès, en surface de laquelle sont formés les contacts ohmiques S et D pour constituer les électrodes de source et drain du transistor. Dans cet agencement de couches, le matériau GaInAs pour réaliser la couche 31 de canal présente une faible largeur de bande interdite, alors que le matériau AlInAs pour réaliser la couche 22 d'espaceur, et la couche 23 fortement dopée pour servir de donneur, présente une plus grande largeur de bande interdite. Dans ces conditions, un gaz bidimensionnel d'électrons s'établit à l'interface des couches 31 et 22. Un tel agencement réalisé en InP est connu sous le nom de "super" HEMT du fait qu'à ce jour il fournit de meilleures performances que d'autres HEMTs connus depuis longtemps de l'homme du métier et réalisés sur GaAs. En effet, dans les supers HEMTs, la différence entre les largeurs de bande interdite des matériaux de l'hétérojonction est plus grande.
   Mais l'invention peut néanmoins s'appliquer à la réalisation des HEMTs sur GaAs.
   Dans ce cas, le transistor comprend au moins sur le substrat 10, la couche 31 formant le canal, non dopée intentionnellement et de faible largeur de bande interdite, et la couche donneur 23 de grande largeur de bande interdite et fortement dopée pour fournir des porteurs de charge.
   Le procédé de réalisation des couches épitaxiales sera favorablement une technique connue de l'homme du métier telle que MBE ou MOCVD ;
b) formation (figure 2a) en surface de l'empilement 11, d'un masque M, par exemple en photorésist, couvrant et délimitant la zone active du futur transistor ;
c) gravure anisotrope de l'empilement 11 (voir figure 2b) jusqu'au substrat 10, avec sous-gravure sous le masque M, pour former les flancs 100 du MESA, flancs qui montrent une pente du fait de la sous-gravure. Ce type de gravure sera favorablement réalisé au moyen d'une gravure humide dans un mélange de H₃PO₄, H₂O₂, H₂O dans les proportions respectives de 3 : 1 : 20. Par sous-gravure, il faut entendre que le sommet du MESA est plus étroit que le masque M ;
d) réalisation (voir la figure 2c) par dépôt anisotrope d'une couche K d'un bon diélectrique. Par bon diélectrique, il faut entendre tout diélectrique habituellement utilisé pour isoler entre eux les différents niveaux métalliques dans un circuit intégré. On choisira par exemple le Si₃N₄ (nitrure de silicium) ou bien SiO₂ (silice). Par dépôt anisotrope, il faut entendre le dépôt d'une épaisseur uniforme sur toutes les régions du transistor : couches actives formant MESA, masque M et substrat autour du transistor ;
e) gravure isotrope de type RIE (de l'anglais Reactive Ion Etching) jusqu'à l'élimination de la couche diélectrique K sur le masque M et sur le substrat (voir la figure 2d). Cette gravure isotrope étant très directive, perpendiculairement au substrat, la couche diélectrique K est maintenue dans les régions protégées par le masque M, c'est-à-dire particulièrement sur les flancs 100 du MESA. Cet effet est obtenu en éliminant sélectivement la couche diélectrique K sans attaquer la couche de masque M. Dans le cas où M est une photorésist et où K est le Si₃N₄, les gaz d'attaque pour pratiquer la RIE seront favorablement le mélange SF₆-CHF₆ ;
f) le masque M en photorésist est ensuite éliminé par tout moyen connu de l'homme du métier. Le résultat de cette étape est montré sur la figure 2e.
   Le procédé comprend ensuite des étapes conventionnelles déjà connues de l'homme du métier :
g) formation de contacts ohmiques S et D ainsi que des connexions C_{S} et C_{D} en surface du diélectrique K sur les flancs 100 du MESA, et des plots P_{S} et P_{D} (voir la figure 3) ;
h) formation d'une cannelure 101, ou ouverture de grille pour dénuder la couche 24 dite Schottky, par gravure appropriée de la couche d'encapsulation 32 (voir la figure 2f) en coupe selon AA', et la figure 3 en coupe selon BB').
i) formation (voir les figures 2g et 3) de la métallisation de type Schottky de grille G, dans la cannelure, ainsi que de la connexion C_{G} en surface du diélectrique K sur un flanc 100 du MESA, et du plot P_{G}.

Les avantages de ce procédé sont que :
- l'étape de réalisation du masque M délimitant la zone active du transistor est équivalente à celle d'un masque délimitant la région d'isolation par implantation ionique dans l'art antérieur ;
- l'étape de gravure anisotrope par voie humide pour former le MESA est d'un faible coût devant l'étape d'implantation ionique connue de l'art antérieur. Le MESA constitue une isolation beaucoup plus efficace du transitor ;
- l'étape de recuit d'implantation est évitée ;
- le dépôt de nitrure de silicium Si₃N₄ ou de silice SiO₂ peut être fait de manière concomitante avec la protection d'autres régions du circuit intégré, donc cette étape ne rallonge pas le procédé ;
- la gravure RIE ne nécessite aucun masque spécial, puisque le masque M délimitant la région active, déjà en place, est utilisé.

Des tests pratiqués sur le transistor HEMT obtenu par le procédé selon l'invention, montrent que le courant de fuite du transistor travaillant dans les mêmes conditions que celui de l'état de la technique cité, est tout aussi faible, ceci plutôt par référence avec le texte du document cité qu'avec la figure présentée, dont l'échelle ne permet pas d'apprécier réellement la valeur du courant de fuite en inverse du transistor monté en diode. Dans le transistor obtenu par le procédé de l'invention, ce courant de fuite peut être considéré comme nul. D'autre part, en direct, les performances du transistor selon l'invention sont améliorées, par rapport à celles du transistor connu.

Dans le tableau I, l'indication de la concentration en indium dans le matériau fournit la concentration préférée d'indium dans le matériau ternaire pour obtenir l'accord de maille avec le substrat en InP.

Le métal pour réaliser le contact Schottky de grille G sera favorablement l'alliage TiPtAu. La métallisation des contacts ohmiques de source S et drain D sera favorablement obtenue au moyen de déposition de AuGe/Ni/Au.

Dans la réalisation de l'empilement 11 des couches actives, la couche tampon 21 peut éventuellement, dans une variante, être remplacée par un super réseau.

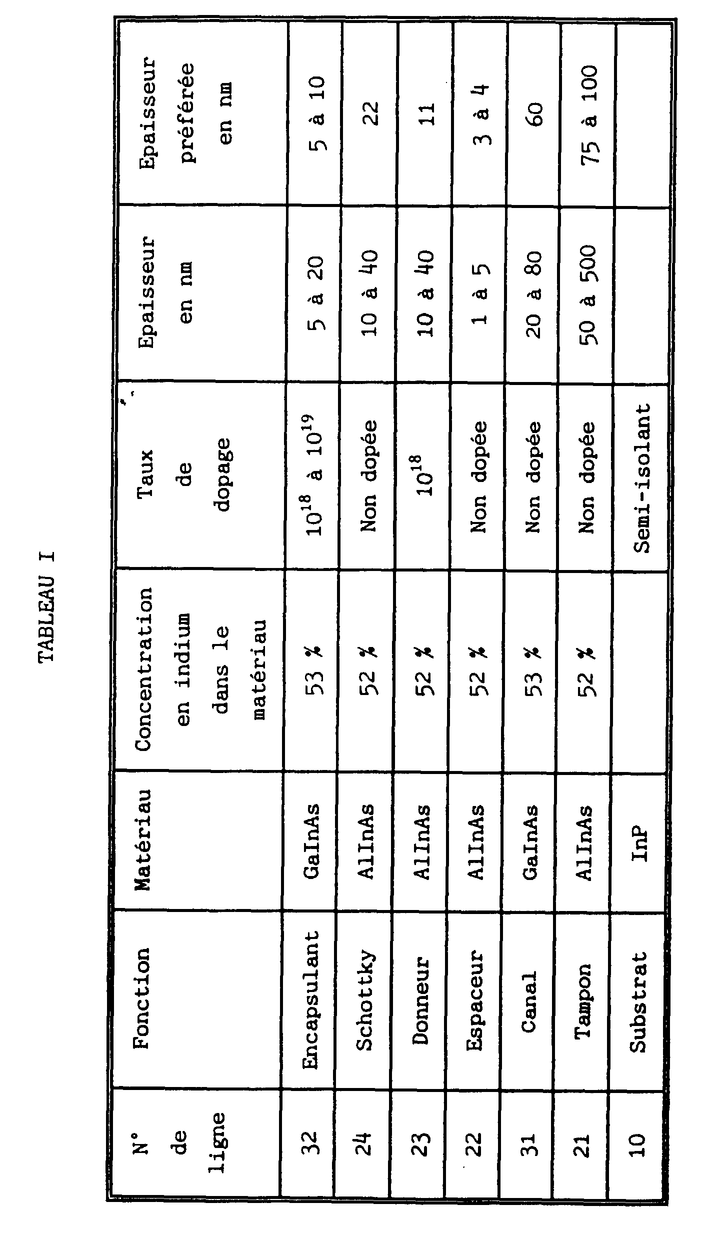

## Revendications

1. Procédé de réalisation d'un circuit intégré sur un substrat (10) comprenant des étapes pour former un transistor à haute mobilité électronique (HEMT), ces étapes incluant :
- la réalisation d'un empilement (11) de couches, réalisées sur le substrat, parmi lesquelles se trouvent au moins une couche de canal (31) en un matériau de faible largeur de bande interdite, faiblement dopée, pour former le canal du transistor, et une couche donneur (23) d'un matériau de grande largeur de bande interdite, fortement dopée, pour fournir des électrons,
- la réalisation d'une zone d'isolation vis-à-vis des autres éléments du circuit intégré tout autour du transistor,
- la réalisation d'électrodes de grille, et de source et drain,
caractérisé en ce que, pour la réalisation de la zone d'isolation, il comprend aussi les étapes de :
- formation en surface de l'empilement de couches, d'un masque (M) couvrant et délimitant la zone active du transistor ;
- gravure anisotrope de l'empilement de couches jusqu'au substrat (10) avec sous-gravure sous le masque (M), pour isoler la zone active du transistor par un MESA ;
- réalisation par dépôt anisotrope d'une couche diélectrique (K) ;
- gravure directive de la couche diélectrique (K) en conservant les parties de cette couche (K) qui sont protégées par le masque (M) du fait de la sous-gravure et qui sont disposées sur les flancs du MESA autour de la zone active du transistor ;
- élimination du masque (M).

2. Procédé selon la revendication 1, caractérisé en ce que, lors de la réalisation de l'empilement (11) de couches, on réalise, entre la couche de canal (31) et la couche donneur (23), une couche (22) de matériau de largeur de bande interdite plus grande que celle de la couche canal (31), faiblement dopée, pour que puisse se former un gaz bidimensionnel d'électrons à l'interface avec cette couche canal et pour séparer spatialement les électrons de ce gaz bidimensionnel des charges de la couche donneur (23), et on réalise, en surface de la couche donneur (23), une couche de grille en materiau (24), non dopée, de grande largeur de bande interdite, pour recevoir une métallisation de grille (G) de type Schottky.

3. Procédé selon la revendication 2, caractérisé en ce que, dans l'étape de formation de l'empilement de couches (11), on réalise, entre le substrat (10) et la couche de canal (31), une couche tampon (21) du matériau de la plus grande largeur de bande interdite, et en ce que, en surface de la couche de grille (24) on réalise une couche d'encapsulation (32) fortement dopée du matériau ayant la plus faible largeur de bande interdite, pour recevoir les contacts de source et drain.

4. Procédé selon la revendication 3, caractérisé en ce que pour la réalisation des électrodes de contact il comprend successivement :
- la formation des contacts ohmiques de source et drain sur la couche d'encapsulation (32) et la formation des connexions de source et drain C_{S}, C_{D} sur le diélectrique (K) sur les flancs du MESA,
- la formation d'une cannelure (101) servant d'ouverture de grille par gravure de la couche d'encapsulation (32),
- la formation, dans la cannelure, de la métallisation de grille de type Schottky et la formation de la connexion de grille C_{G} sur le diélectrique (K) sur un flanc du MESA.

5. Procédé selon l'une des revendications précédentes, caractérisé en ce que le substrat est en phosphure d'indium (InP), le matériau de plus faible largeur de bande interdite est l'arséniure d'indium et de gallium (GaInAs), et le matériau de plus grande largeur de bande interdite est l'arséniure d'indium et d'aluminium (AlInAs).

6. Procédé selon l'une des revendications précédentes, caractérisé en ce que la couche diélectrique (K) pour l'isolation du MESA est choisie parmi la silice (SiO₂) et le nitrure de silicium (Si₃N₄).

## Patentansprüche

1. Verfahren zur Realisierung einer integrierten Schaltung auf einem Substrat (10) mit den Schritten zum Bilden eines Transistors mit hoher Elektronenbeweglichkeit (HEMT: High Electron Mobility Transistor), wobei die Schritte umfassen:
- die Realisierung eines Stapels (11) aus Schichten auf dem Substrat, unter welchen Schichten sich zumindest eine schwach dotierte Kanalschicht (31) aus einem Material mit geringem Bandabstand zur Bildung des Kanals des Transistors und eine stark dotierte Donatorschicht (23) aus einem Material mit großem Bandabstand zur Lieferung der Elektronen befinden,
- die Realisierung einer Isolierzone gegenüber den anderen Elementen der integrierten Schaltung, die den Transistor vollständig umgibt,
- die Realisierung von Gate-, Source- und Drain-Elektroden,
dadurch gekennzeichnet, daß es zur Realisierung der Isolierzone außerdem die folgenden Schritte umfaßt:
- Bildung einer Maske (M), die die aktive Zone des Transistors überdeckt und begrenzt, auf der Oberfläche des Schichtenstapels;
- anisotropes Ätzen des Schichtenstapels bis zum Substrat (10) mit Unterätzung unter der Maske (M) zum Isolieren der aktiven Zone des Transistors mit Hilfe eines Mesa;
- Realisieren einer dielektrischen Schicht (K) durch anisotrope Abscheidung;
- Richtungsätzen der dielektrischen Schicht (K) unter Beibehaltung der Teile dieser Schicht (K), die von der Maske (M) infolge der Unterätzung geschützt werden und die an den Flanken des Mesa um die aktive Zone des Transistors herum angeordnet sind;
- Beseitigung der Maske (M).

2. Verfahren nach Anspruch 1, dadurch gekennzeichnet, daß während der Realisierung des Stapels (11) aus Schichten zwischen der Kanalschicht (31) und der Donatorschicht (23) eine schwach dotierte Schicht (22) aus Material mit einem größeren Bandabstand als dem der Kanalschicht (31) realisiert wird, damit sich ein zweidimensionales Elektronengas an der Grenzfläche mit dieser Kanalschicht bilden kann und um die Elektronen dieses zweidimensionalen Gases von den Ladungen der Donatorschicht (23) räumlich zu trennen, und daß auf der Oberfläche der Donatorschicht (23) eine nicht dotierte Gate-Schicht aus Material mit großem Bandabstand realisiert wird, um eine Gate-Metallisierung vom Schottky-Typ zu erhalten.

3. Verfahren nach Anspruch 2, dadurch gekennzeichnet, daß beim Schritt des Bildens des Schichtenstapels (11) zwischen dem Substrat (10) und der Kanalschicht (31) eine Pufferschicht (21) aus Material mit größtem Bandabstand realisiert wird und daß auf der Oberfläche der Gate-Schicht (24) eine stark dotierte Einschlußschicht (32) aus dem Material mit kleinstem Bandabstand realisiert wird, um die Source- und Drainkontakte zu erhalten.

4. Verfahren nach Anspruch 3, dadurch gekennzeichnet, daß es zur Realisierung der Kontaktelektroden hintereinander umfaßt:
- die Bildung ohmscher Source- und Drain-Kontakte auf der Einschlußschicht (32) und die Bildung der Source- und Drain-Verbindungen C_{S}, C_{D} auf dem Dielektrikum (K) auf den Flanken des Mesa,
- die Bildung eines als Gate-Öffnung dienenden Grabens (101) durch Ätzen der Einschlußschicht (32),
- die Bildung der Gate-Metallisierung vom Schottky-Typ in dem Graben und die Bildung des Gate-Anschlusses C_{G} auf dem Dielektrikum (K) auf einer Flanke des Mesa.

5. Verfahren nach einem der vorhergehenden Ansprüche, dadurch gekennzeichnet, daß das Substrat aus Indiumphosphid (InP) besteht, das Material mit kleinstem Bandabstand Indiumgalliumarsenid (GaInAs) ist und das Material mit größtem Bandabstand Aluminiumindiumarsenid (AlInAs) ist.

6. Verfahren nach einem der vorhergehenden Ansprüche, dadurch gekennzeichnet, daß die dielektrische Schicht (K) zur Isolation des Mesa entweder Siliciumoxid (SiO₂) oder Siliciumnitrid (Si₃N₄) ist.

## Claims

1. A method of manufacturing an integrated circuit on a substrate (10), which method comprises steps for forming a high electron mobility transistor (HEMT), these steps including:
- the realisation of a superimposed structure (11) of layers provided on the substrate, among which there is at least a channel layer (31) of a material having a narrow bandgap which is weakly doped for forming the channel of the transistor, and a donor layer (23) of a material having a wide bandgap which is strongly doped for providing electrons,
- the realisation of an insulation zone relative to other elements of the integrated circuit, which completely surrounds the transistor and
- the realisation of gate, source and drain electrodes, characterized in that, for the realisation of the insulation zone, it comprises the steps of:
- providing a mask (M) at the surface of the superimposed structure of layers, which mask covers and defines the active zone of the transistor;
- anisotropic etching the superimposed structure of layers down to the substrate (10) with underetching under the mask (M) so as to insulate the active zone of the transistor by means of a mesa;
- realising a dielectric layer (K) by anisotropic deposition;
- etching the dielectric layer (K) directionally while maintaining the portions of this layer (K) which are protected by the mask as a result of the under-etching and are disposed on the flanks of the mesa around the active zone of the transistor;
- eliminating the mask (M).

2. A method as claimed in Claim 1, characterized in that, during the realisation of the superimposed layer structure (11), a weakly doped layer (22) of a material having a wider bandgap than the channel layer (31) is realised between said channel layer and the donor layer (23), so that a two-dimensional electron gas can be formed at the interface with said channel layer and the electrons of this two-dimensional gas are spatially separated from the charges of the donor layer (23), and in that a layer of undoped gate material (24) having a wide bandgap is realised at the surface of the donor layer (23) for receiving a gate metallisation (G) of the Schottky type.

3. A method as claimed in Claim 2, characterized in that during the step of forming the superimposed layer structure (11), a buffer layer (21) of the material having the widest bandgap is provided between the substrate (10) and the channel layer (31), and in that a strongly doped encapsulating layer (32) of the material having the narrowest bandgap is provided at the surface of the gate layer (24) for receiving the source and drain contacts.

4. A method as claimed in Claim 3, characterized in that, for realising the contact electrodes, it comprises in that order:
- the formation of ohmic source and drain contacts on the encapsulating layer (32) and the formation of source and drain connections C_{S} and C_{D} on the dielectric (K) on the flanks of the mesa,
- the formation of a groove (101), which serves as a gate opening, by etching of the encapsulating layer (32),
- the formation of the Schottky-type gate metallisation in the groove and the formation of the gate connection C_{G} on the dielectric (K) on a flank of the mesa

5. A method as claimed in any one of the preceding Claims, characterized in that the substrate is made of indium phosphide (InP), the material having the narrowest bandgap is gallium-indium arsenide (GaInAs), and the material having the widest bandgap is aluminium-indium arsenide (AlInAs).

6. A method as claimed in any one of the preceding Claims, characterized in that the material of the dielectric layer (K) for the insulation of the mesa is either silica (SiO₂) or silicon nitride (Si₃N₄).
